(19) Europäisches Patentamt
European Patent Office
Office européen des brevets

(11) Publication number: 0 171 242 B1

(12) EUROPEAN PATENT SPECIFICATION

(45) Date of publication of patent specification: 13.06.90

(51) Int. Cl.$^5$: H 01 L 33/00

(21) Application number: 85305361.9

(22) Date of filing: 26.07.85

# (54) Methods of making semiconductor light-emitting devices and vapour phase growth apparatus used for carrying out the methods.

(30) Priority: 28.07.84 JP 158151/84

(43) Date of publication of application:
12.02.86 Bulletin 86/07

(45) Publication of the grant of the patent:
13.06.90 Bulletin 90/24

(84) Designated Contracting States:
DE FR GB NL

(56) References cited:
EP-A-0 052 979
DE-A-2 830 081
GB-A-2 015 982
US-A-4 329 189

JOURNAL OF CRYSTAL CROWTH, vol. 55, no. 1, October 1981, pages 64-73, North-Holland, Amsterdam, NL; J.P. DUCHEMIN et al.: "GaInAs and GaInAsP materials grown by low pressure MOCVD for microwave and optoelectronic applications"

(73) Proprietor: SONY CORPORATION
7-35 Kitashinagawa 6-Chome Shinagawa-ku
Tokyo 141 (JP)

(72) Inventor: Ikeda, Masao c/o Patent Division
Sony Corporation 6-7-35 Kitashinagawa
Shinagawa-ku Tokyo 141 (JP)
Inventor: Mori, Yoshifumi c/o Patents Division
Sony Corporation 6-7-35 Kitashinagawa
Shinagawa-ku Tokyo 141 (JP)
Inventor: Kawai, Hiroji c/o Patents Division
Sony Corporation 6-7-35 Kitashinagawa
Shinagawa-ku Tokyo 141 (JP)

(74) Representative: Thomas, Christopher Hugo et al
D Young & Co 10 Staple Inn
London WC1V 7RD (GB)

(56) References cited:
JAPANESE JOURNAL OF APPLIED PHYSICS, vol. 23, no. 8, August 1984, pages L 606-L 609, Part 2, Tokyo, JP; Y. BAN et al.: " MOCVD growth and characterization of (AlxGa1-x)yIn1-yP/GaAs"

EP 0 171 242 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

This invention relates to methods of making semiconductor light-emitting devices and vapour phase growth apparatus used for carrying out the methods.

Semiconductive light-emitting devices using semiconductor compounds of elements of groups III—V of the periodic table, for example, double hereto junction-type semiconductor laser diodes, include, as particularly shown in Figure 1 of the accompanying drawings, a substrate 1 of a single crystal semiconductor compound, on which a first clad layer 2, an active layer 3, a second clad layer 4 and a cap layer 5 are epitaxially grown in that order. An insulating layer 6, such as of $Si_3N_4$, is formed on the cap layer 5, and has a through-hole in the form of a strip window 6a, through which one electrode 7 passes and is attached to the cap layer 5 in ohmic contact. Another electrode 8 is deposited on the other side of the substrate 1 in ohmic contact.

In the light-emitting device using this type of semiconductive compound, it is convenient to use, as the substrate 1, a single crystal of GaAs as it is relatively inexpensive and is widely used.

On the other hand, when a mixed crystal of elements of groups III—V, for example AlGaInP, is used as a semiconductor laser diode, lattice matching on the GaAs substrate 1 is possible with the highest direct transition-type band gap, permitting oscillation of light having a short wavelength. Thus, wide utility of the mixed crystal can be expected. However, with the semiconductor AlGaInP compound, epitaxial growth by conventional vapour phase epitaxial growth techniques or liquid phase epitaxial growth techniques is very difficult due to thermodynamic limitations.

Formation of the AlGaInP semiconductor layer by the metal organic chemical vapour deposition (MOCVD) method has therefore been proposed. Where the MOCVD method is applied to the formation of AlGaInP compounds of groups III—V, it is common to use gases of organic metals such as triethyl compounds, for example triethylaluminium, triethylgallium and triethylindium (hereinafter referred to simply as TEAl, TEGa and TEIn, respectively) as starting feeds for Al, Ga, and In, which are metals of groups III—V. Moreover, phosphine, $PH_3$, is used as a starting gas for phosphorus. However, TEIn is thermally unstable, whereas $PH_3$ is very thermally stable. When the two gases are mixed at room temperature, a nonvolatile intermediate product is formed and deposited on wall surfaces of a reaction furnace, thus making it difficult to form a crystalline epitaxial layer of good quality in a well-controlled manner. In order to suppress the intermediate reaction in the MOCVD method, it is usual to reduce the pressure in the reaction furnace or to feed the $PH_3$ after decomposition.

However, the growth under reduced pressure involves not only a complicated apparatus, but also low controllability. The method in which $PH_3$ has been preliminarily decomposed, is undesirable because the feed gas temperature has to be increased to cause the decomposition. When the decomposed gas is combined and mixed, for example, with TEIn, which is thermally unstable as mentioned above, for passage to the substrate surface, TEIn tends to suffer unfavourable decomposition or intermediate reaction. Therefore, an AlGaInP epitaxial layer having good characteristics cannot be obtained in a well-controlled manner.

Journal of Crystal Growth Vol. 55, no. 1, October 1981 pages 64 to 67 is concerned with the fabrication of GaInAsP/InP lasers by a low pressure MOCVD method.

According to the present invention there is provided a method of making a semiconductive light-emitting device by forming, on a substrate by epitaxial growth, a plurality of layers of semiconductive III—V compounds, the method comprising the steps of:

heating the substrate to a temperature of 580°C to 630°C;

separately flowing a gas of triethyl compounds of metals of group III and a gas of phosphine;

mixing said gases together immediately before they reach the substrate, the ratio of the phosphine to the triethyl compounds of metals of group III being at least 300:1, thereby forming a semiconductive III—V layer of a selected composition on the substrate; and

repeating the above procedure so as successively to form a plurality of layers on the substrate, the plurality of layers comprising semiconductive compounds, each of which are represented by the formula:

$$(Al_yGa_{1-y})_xIn_{1-x}P$$

in which $0 \leq y \leq 1$ and $0 \leq x \leq 1$.

According to the present invention there is also provided a vapour phase growth apparatus for making a semiconductive light-emitting device by epitaxial growth of semiconductive III—V compounds, the apparatus comprising:

an atmospheric reaction furnace; and

a substrate mount positioned in said furnace, such that a gas passage having an inlet is established between the substrate mount and an inner side wall of the reaction furnace;

characterised by:

a first starting gas feed port located at the inlet of the gas passage and through which triethyl compounds of metals of group III are caused to flow; and

a second starting gas feed port located between the inlet of the gas passage and the first starting material gas feed port and for the flow of phosphine;

the second starting gas feed port being inclined with respect to the first starting gas feed port, the first and second starting gas feed ports having substantially the same shape and size, the gas of the triethyl compounds of metals of group III and the phosphine flowing from the first and second starting gas feed port, respectively, and being mixed immediately upstream of a substrate mounted on the substrate mount which is located near the inlet to the gas passage, so that the mixed gas flows over and along the substrate surface.

The invention will now be described by way of example with reference to the accompanying drawings, throughout which like parts are referred to by like references, and in which:

Figure 1 is a schematic sectional view showing a conventional semiconductive laser diode;

Figure 2 is a schematic, enlarged, sectional view of an embodiment of a vapour phase growth apparatus according to the invention;

Figures 3 and 4 are sectional views, taken along the lines A—A and B—B respectively of Figure 2;

Figure 5 is a graph showing the relation between epitaxial growth rate and distance of a substrate from an inlet end;

Figure 6 is a graph showing the relation between luminous intensity and substrate temperature;

Figure 7 is a graph showing the relation between luminous intensity and $PH_3$/III;

Figure 8 is an enlarged, sectional view of a semiconductor laser device obtained by a method according to the invention; and

Figures 9 and 10 are, respectively, curves of an output characteristic and an emission spectrum respectively;

In Figures 2 to 4, there is shown an embodiment of vapour phase growth apparatus 10. The apparatus 10 includes a reaction furnace 11 made, for example, of a quartz tube. In the furnace 11, there is provided a substrate mounting 13, which is made, for example, from graphite, and on which a substrate 1 is mounted. A plurality of semiconductor layers of AlGaInP compounds are epitaxially grown on the substrate 1. The mounting 13 is heated so that the substrate 1 can be heated to a predetermined temperature. The substrate 1 consists of a GaAs monocrystal wafer.

A heater for the mounting 13, and thus for the substrate 1, may be a high frequency inductor heater using a high frequency coil 14 provided around the furnace 11. A temperature detector such as a thermocouple 5 is provided for detecting the temperature of the mounting 13.

The mounting 13 is provided in face-to-face relation with one side wall, for example, an upper wall surface 11a, of the furnace 11 to maintain a given space g therebetween, so that a gas passage 16 having a rectangular cross-section with a width W and a height g is established between the upper surface of the mounting 13 and the upper wall surface 11a of the furnace 11 along the longitudinal axis of the furnace 11. In this manner, the surface of the substrate 1 on the mounting 13 is exposed to the passage 16. The substrate 1 is located near an opening forming an inlet end 16a of the passage 16.

A first starting gas feed pipe 19 having a first starting gas feed port 17, extends to and faces the inlet end 16a of the passage 16. In other words, the first feed port 17 is arranged almost coaxially with the passage 16, so that gas from the first feed port 17 passes along the axial direction of the passage 16.

The first feed port 17 has a width W1 and a height d1, sufficient to cover (that is, at least as large as) the diameter or width of the substrate 1 mounted on the mounting 13.

A second starting gas feed pipe 20 is provided which has a second starting gas feed port 18 and an opening between the gas passage 16 and the feed port 17 facing the passage 16. The second feed port 18 is arranged such that the direction of gas flow from the second feed port 18 is inclined (that is, is not parallel) with respect to the axial direction of the first feed port 17 and the passage 16. The direction of the gas flow from the second feed port 18 may be, for example, at right angles to the gas flow from the first feed port 17.

The first and second feed ports 17 and 18 are designed to have almost the same shape and size. More particularly, the width W2 and the height d2 of the second feed port 18 are determined, such that W2 is approximately equal to W1 and d2 is approximately equal to d1. The second feed port 18 is so arranged that the width W2 is along the respective widths W and W1 of the inlet end 16a and the first feed port 17, and that the width W2 is coincident with the width W1 of the first feed port 17.

A cooling means 21, such as, for example, a cooling tube through which cooling water is passed, is provided along the wall surface which faces the substrate 1 in the furnace 11 to the extent that the passage 16 and part of the first feed tube 19 are covered.

In this arrangement, triethyl compounds of metals of group III, for example, TEGa (that is, $(C_2H_5)_3Ga$), TEAl (that is, $(C_2H_5)_3Al$) or TEIn (that is, $(C_2H_5)_3In$), are mixed in given mixing ratios and fed or caused to flow from the first feed pipe 19 by entrainment with an $H_2$ carrier gas in an amount less than 0.1% of the mixture. Phosphine, $PH_3$, is fed from the second feed pipe 20 and entrained in an $H_2$ carrier gas in an amount less than 10%. Thus, the first and second starting gases are combined and mixed downstream of the feed ports 17 and 18 or immediately upstream of the inlet end 16a of the passage 16, and immediately upstream of the substrate 1. The mixed gas flows into the passage 16 and passes along and over the surface of the substrate 1 as shown by an arrow a'. At a position downstream of the feed ports 17 and 18, the second starting gas is uniformly mixed with the first starting gas, whereupon the first starting gas from the first feed port 17 should form a main stream. The mixed gas is passed, without disturbing the main stream, along the surface of the substrate 1 in the passage 16. In the passage 16, the mixed gas flows at a flow rate of 80 cm/second or more in order that the organic metal compounds such as, for example, TEIn, do not

decompose or react in the gas phase near the surface of the substrate 1. This gas flow can be achieved not only by the arrangement of the second feed port 18 at an inclined angle, for example, at right angles, with respect to the first feed port 17 and the passage 16, but also with the flow rates of the first and second gases. In practice, the flow rate in the passage 16 is determined to be almost the same as the flow rate at the first feed port 17. Assuming that the sectional areas of the first and second feed ports 17 and 18 are taken as A and B, respectively, with flow rates from the respective feed ports 17 and 18 being taken as a and b, and a sectional area of the gas passage 16 is taken as C, and a flow rate in the passage 16 is taken as c (c=a+b), the following relations should be satisfied in order to assure only a small disturbance of the gas flow:

$$a/A=(a+b)/C=c/C \quad (1)$$

$$a/A \text{ is greater than } b/B \quad (2)$$

Now, when A=B=3 mm×30 mm and C=3.5×30 mm, the above equations are satisfied when a=6 litres/minute and b=1 litre/minute. Based on the above, the feeds of the first and second gases from the first and second feed pipes 19 and 20 are, respectively, selected as 6 litres/minute and 1 litre/minute.

In order to permit the first starting gas from the first feed port 17 to flow into the passage 16 as the main stream without creating a disturbance of the stream, it is desirable to make the upper surface level of the mounting 13 or the surface level of the substrate 1 lower than the lower surface of the feed port 17.

In this manner, the mixed gas of the triethyl compound TEGa, TEAl or TEIn and the phosphine, $PH_3$, flows over the surface of the substrate 1, by which AlGaInP semiconductor layers can be epitaxially grown on the substrate 1. During the epitaxial growth, the substrate should be maintained at a temperature of 580°C to 630°C. The mixing ratio of the triethyl compounds and phosphine should be at least 1:300.

The cooling means 21 is provided to cool portions other than the substrate 1 in the furnace 11 (which is heated by the heated substrate 1) so that the starting gases are not unstably decomposed and are not involved in side reactions.

Using the apparatus 11, $(Al_yGA_{1-y})_xIn_{1-x}$ semiconductor layers were epitaxially grown on the substrate 1. The results of measurement of the growth rate in relation to the direction of the starting gas flow are shown in Figure 5. In this figure, the abscissa indicates a distance from the inlet end 16a of the passage 16. Curves 51a, 51b and 51c are for semiconductor compositions of the above formula in which y=0 and x=0.5. Curve 52 is for a composition of the formula in which y=1 and x=0.5, and curve 53 is the case where y=0.5 and x=0.5. Curves 54a, 54b and 54c are for comparison in which $Al_{0.3}Ga_{0.7}As$ is epitaxially grown.

In Table 1, the growth efficiency is shown in which a number of organic metals are epitaxially grown using the apparatus 11. According to the results of the table, the growth efficiencies of TEIn and TEAl are close to the efficiencies of other organic metals, revealing that the side reactions can be suppressed. In Table 1, the vapour pressure of each organic metal used for calculation of the growth efficiency is also shown.

TABLE 1

| Organic metal | Vapour pressure (mmHg) | Growth efficiency (μm/minute) |
|---|---|---|
| TEIn (15°C) | 0.19 | $4\times10^3$ |
| TEGa (−5°C) | 0.87 | $3-5\times10^3$ |
| TEAl (20°C) | 0.029 | $7-9\times10^3$ |
| TMIn (30°C) | 3.5 | $4\times10^3$ |
| TMGa (−15°C) | 30 | $3\times10^3$ |

Table 2 shows the results of measurement of the growth efficiency where the flow rate of starting gases in the passage 16 was increased over the flow rate used in Table 1.

TABLE 2

| Organic metal | Growth efficiency (µm/minute) Metals of Group III/ $P(PH_3)$ compounds | Metals of Group III/ $As(AsH_3)$ compounds |
|---|---|---|
| TEIn | $9.5\times10^3$ | |
| TEGa | $7.5\times10^3$ | $1.1\times10^4$ |
| TEAl | $1.6\times10^4$ | $2.2\times10^4$ |

In Table 2, the metals of group III and As in the form $AsH_3$ were epitaxially grown and shown for comparison. From the table it will be seen that high growth efficiencies are attained using group III metal/P compounds.

With the method and apparatus 11 described, an epitaxial layer of $Ga_{0.51}In_{0.49}P$ was formed on the GaAs substrate 1 by feeding $H_2$ gas containing TEGa and TEIn gases from the first feed pipe 19, and $H_2$ gas containing $PH_3$ from the second feed pipe 20 and subjected to measurement of photoluminescence. The temperature of the substrate 1 was set at 580°C to 630°C and the feed ratio ($PH_3$/III) of the phosphine gas to the gases of the triethyl compounds of metals of group III was at least 300:1. Figure 6 shows the relation between luminous intensity and substrate temperature, and Figure 7 shows the relation between luminous intensity and ($PH_3$/III) for a substrate temperature of 620°C. As will be apparent from Figure 6 it is preferable to set the substrate temperature at 580°C to 630°C in order to obtain an epitaxial layer of good characteristics. Within this temperature range, the decomposition rate of $PH_3$ is low, so that $PH_3$ should be fed, in excess, so as to obtain a pressure of phosphorus necessary for growth and sufficient for suppressing decomposition of the grown layer. Figure 7 reveals that $PH_3$/III should be at least 300:1.

The semiconductor laser device of Figure 8 was then fabricated. For the fabrication, the substrate temperature was 600°C and the flow rate of all gases was 6 litres/minute. ($a=6\times6/7$ litres/minute and $b=6\times1/7$ litres/minute). More particularly, the laser device was fabricated as follows: there were formed, on an n-type GaAs substrate 1 doped with Si, a buffer layer 61, a first clad layer 62, an active layer 63, a second clad layer 64, and a cap layer 65 in this order by epitaxial growth using the MOCVD method. The buffer layer 61 was an n-type GaAs layer doped with Se, the first clad layer 62 was an n-type $Al_{0.21}Ga_{0.31}In_{0.48}P$ layer doped with Se, the active layer 63 was an undoped $Ga_{0.52}In_{0.48}P$ layer. The second clad layer 64 was a p-type $Ga_{0.52}In_{0.31}In_{0.48}P$ layer doped with Zn, and the cap layer 65 was a p-type $Ga_{0.52}In_{0.48}P$ layer doped with Zn. The layers 61 to 65 were respectively formed by feeding TEGa, TEAl and TEIn as starting gases for the Ga, Al and In metals of group III from the first feed pipe 19 in mixing ratios corresponding to the respective compositions of the layers 61 to 65, and also feeding As or P of group V, in the form of $AsH_3$ or $PH_3$, from the second feed pipe 20 in amounts corresponding to the compositions of the respective layers 61 to 65. The starting gases for Se and Zn used as the dopants were selenium halide and dimethylzinc, respectively. Selenium halide was fed along with $PH_3$ or $AsH_3$, and dimethylzinc was fed along with TEGa TEAl and/or TEIn.

The cap layer 65 was covered with an insulating layer 66 consisting of $Si_3N_4$, in which an opening was made to form a strip window 66a. An electrode 67 was attached to the cap layer 65 through the window 66a in ohmic contact. Another electrode 68 was formed on the back surface of the substrate 1. The resulting double hetero junction-type semiconductor laser device can be continuously oscillated at 77°K. It should be noted that the strip window 66a was designed to have a width of 8 µm and a length of 250 µm. At 77°K, the threshold current, $I_{th}$, was 55 mA and the oscillation wavelength was 0.653 µm. Figure 9 shows an output characteristic of the laser device and Figure 10 shows an emission spectrum of the device.

The semiconductor laser diode described, exhibits the short wave oscillation inherent to semiconductor AlGaInP compounds.

As described hereinabove, the vapour phase growth apparatus is designed to have a specific positional relation between feed portions for the respective starting gases and also a specific positional relation between the substrate, on which epitaxial growth is performed, and a gas passage in such a way that starting gas containing metals of group III and a starting gas containing an element of group V are mixed just before reaching the substrate. In addition, the starting gases are fed to the substrate in such a way that the gases containing metals of group III are fed as the main stream without disturbing the stream. In this manner, the elements of groups III and V react with one another, although the starting materials used have different decomposition rates, thereby effectively suppressing formation of side reaction products. In the method described, the substrate temperature and the ratio of the starting gases containing metals of group III and the starting gas containing an element of group V are specifically defined, by which a semiconductor light-emitting device of high quality can be obtained. Although the starting gases of metals of group II used are triethyl compounds and the starting gas of an element of group V is in the form of $PH_3$, formation of intermediate products can be avoided without utilizing any vacuum method. Thus, the apparatus can be simplified and is easy to handle, bringing about a number of advantages.

**Claims**

1. A method of making a semiconductive light-emitting device by forming, on a substrate (1) by epitaxial growth, a plurality of layers (61 to 65) of semiconductive III—V compounds, the method comprising the steps of:

heating the substrate (1) to a temperature of 580°C to 630°C;

separately flowing a gas of triethyl compounds of metals of group III and a gas of phosphine;

mixing said gases together immediately before they reach the substrate (1), the ratio of the phosphine to the triethyl compounds of metals of group III being at least 300:1, thereby forming a semiconductive III—V layer of a selected composition on the substrate (1); and

repeating the above procedure so as successively to form a plurality of layers (61 to 65) on the substrate (1), the plurality of layers (61 to 65) comprising semiconductive compounds, each of which are represented by the formula:

$$(Al_yGa_{1-y})_xIn_{1-x}P$$

in which $0 \leq y \leq 1$ and $0 \leq x \leq 1$.

2. A method according to claim 1 wherein selected layers of the plurality of layers (61 to 65) are doped with a dopant of Se or Zn.

3. A method according to claim 1 or claim 2 wherein said gas of triethyl compounds is carried by a hydrogen carrier gas in a concentration less than 0.1%.

4. A method according to claim 1, claim 2 or claim 3 wherein said phosphine is carried by a hydrogen carrier gas in a concentration less than 10%.

5. A method according to any one of the preceding claims wherein said mixture of gases flows over the substrate (1) at a flow rate of 80 cm/minute.

6. A vapour phase growth apparatus (10) for making a semiconductive light-emitting device by epitaxial growth of semiconductive III—V compounds, the apparatus (10) comprising:

an atmospheric reaction furnace (10); and

a substrate mount (13) positioned in said furnace (10), such that a gas passage (16) having an inlet (16a) is established between the substrate mount (13) and an inner side wall (11a) of the reaction furnace (11); characterised by:

a first starting gas feed port (17) located at the inlet (16a) of the gas passage (16) and through which triethyl compounds of metals of group III are caused to flow; and

a second starting gas feed port (18) located between the inlet (16a) of the gas passage (16) and the first starting material gas feed port (17) and for the flow of phosphine;

the second starting gas feed port (18) being inclined with respect to the first starting gas feed port (17), the first and second starting gas feed ports (17, 18) having substantially the same shape and size, the gas of the triethyl compounds of metals of group III and the phosphine flowing from the first and second starting gas feed port (17, 18), respectively, and being mixed immediately upstream of a substrate (1) mounted on the substrate mount (13) which is located near the inlet (16a) to the gas passage (16), so that the mixed gas flows over and along the substrate surface.

7. An apparatus (10) according to claim 6 further comprising heating means (14) for heating the substrate (1) to a temperature of from 580°C to 630°C.

8. An apparatus (10) according to claim 7 or claim 8 wherein said heating means (14) surrounds said reaction furnace (11).

9. An apparatus (10) according to claim 6, claim 7 or claim 8 wherein the second starting gas feed port (18) is at right angles to the first starting gas feed port (17).

10. An apparatus (10) according to any one of claims 6 to 9 wherein the first and second starting gas feed ports (17, 18) have substantially the same width and height.

11. An apparatus (10) according to any one of claims 6 to 10 wherein said substrate mount 13 and a substrate (1) carried thereon are positioned below the lower surface of the first starting gas feed port (17).

**Patentansprüche**

1. Verfahren zur Herstellung von einer halbleitenden lichtemittierenden Anordnung, wobei auf einem Substrat (1) durch epitaxiales Aufwachsen mehrere Schichten (61 bis 65) von halbleitenden III—V-Verbindungen gebildet werden, gekennzeichnet durch die Schritte:

Erhitzen des Substrates (1) auf eine Temperatur von 580°C bis 630°C,

separates Zufließen von einer gasförmigen Triethylverbindung eines Metalls der Gruppe III sowie eines Phosphingases,

Mischen der Gase unmittelbar vor dem Erreichen des Subtrats (1), wobei das Verhältnis des Phosphins zu der Triethylverbindung eines Metalls der Gruppe III wenigstens 300:1 beträgt,

wodurch eine halbleitende III—V-Schicht aus einer ausgewählten Zusammensetzung auf dem Substrat gebildet wird, und

Wiederhohlen des obigen Vorgangs unter aufeinanderfolgender Bildung mehrerer Schichten (61 bis 65) aus den halbleitenden Substanzen, von denen jede der Formel

$$(Al_yGa_{1-y})_xIn_{1-x}P$$

entspricht, mit

$$0 \leq y \leq 1 \text{ sowie } 0 \leq x \leq 1.$$

2. Verfahren gemäß Anspruch 1, bei dem aus den Schichten (61 bis 65) ausgewählte Schichten dotiert werden mit Selon oder Zink als Dotierungsmittel.

3. Verfahren gemäß Anspruch 1 oder 2, bei dem die gasförmige Triethylverbindung durch ein Wasserstoffträgergas in einer Konzentration von weniger als 0,1% befördert wird.

4. Verfahren gemäß Anspruch 1, 2 oder 3, bei dem das Phosphin durch ein Wasserstoffträgergas in einer Konzentration von weniger als 10% befördert wird.

5. Verfahren gemäß einem jeden der vorangehenden Ansprüche, bei dem die Mischung der Gase über das Substrat (1) mit einer Fließgeschwindigkeit von 80 cm/min strömt.

6. Dampfphasenwachstums-Anlage (10) zur Herstellung von halbleitenden lichtemittierenden Anordnungen durch epitaxiales Aufwachsen von halbleitenden III—V-Verbindungen, mit:

einem atmosphärischen Ofen (11) und

einer in dem Ofen (11) so angeordneten Substrat-Unterlage (13), daß ein von einem Einlaß (16a) ausgehender Gasdurchfluß (16) zwischen der Substratunterlage (13) und der inneren Seitenwand (11a) des Reaktionsofens (11) bewirkt wird, gekennzeichnet durch:

eine erste Anstell-Gaszuführöffnung (17), die am Einlaß (16a) des Gasdurchflusses (16) angeordnet ist und durch die die Strömung von Triethylverbindungen der Metalle der Gruppe III erreicht wird,

eine zweite Anstell-Gaszuführöffnung (18), die zwischen dem Einlaß (16a) des Gasdurchflusses (16) und der ersten Gaszuführöffnung (17) angeordnet ist und für die Strömung von Phosphin dient, wobei die zweite Gaszuführöffnung (18) in Bezug auf die erste Gaszuführöffnung (17) schräggestellt ist, die erste und die zweite Gaszuführöffnung im wesentlichen dieselbe Gestalt und Größe haben sowie die gasförmigen Triethylverbindungen von Metallen der Gruppe III und das Phosphin aus der ersten bzw. zweiten Gaszuführöffnung (17, 18) strömen und unmittelbar vor dem Substrat (1) gemischt werden, das auf der Substratunterlage (13) eingespannt und nahe bei dem Einlaß (16a) des Gasdurchflusses (16) angeordnet ist, so daß das Gasgemisch über und längs der Substratoberfläche fließt.

7. Anlage (10) gemäß Anspruch 6, die zusätzlich Erhitzungsmittel (14) zum Erhitzen des Substrats (1) auf eine Temperatur von 580°C bis 630°C aufweist.

8. Anlage gemäß Anspruch 7, bei der das Erhitzungsmittel (14) den Reaktionsofen (11) umgibt.

9. Anlage (10) gemäß Anspruch 6, 7 oder 8, bei der die zweite Gaszuführöffnung (18) im rechten Winkel zu der ersten Gaszuführöffnung (17) angeordnet ist.

10. Anlage (10) gemäß einem jeden der Ansprüche 6 bis 9, bei der die erste und die zweite Gaszuführöffnung (17, 18) im wesentlichen dieselbe Breite und Höhe haben.

11. Anlage (10) gemäß einem jedem der Ansprüche 6 bis 10, bei der die Substratunterlage (13) und ein darauf getragenes Substrat (1) unter der Unterseite der ersten Gaszuführöffnung (17) positioniert sind.

**Revendications**

1. Procédé de fabrication d'un dispositif semiconducteur émetteur de lumière par formation par croissance épitaxiale sur un substrat (1), d'une pluralité de couches (61 à 65) de composés semiconducteurs III—V, le procédé comprenant les étapes suivantes:

chauffage du substrat (1) à une température de 580 à 630°C;

circulation séparée d'un gaz de composés triéthylés des métaux du groupe III et d'un gaz de phosphine;

mélange desdits gaz ensemble immédiatement avant qu'ils atteignent le substrat (1), le rapport de la phosphine aux composés triéthylés des métaux du groupe III étant au moins égal à 300:1, pour former ainsi une couche semiconductrice III—V d'une composition choisie sur le substrat (1); et

répétition du mode opératoire ci-dessus de façon à former successivement une pluralité de couches (61 à 65) sur le substrat (1), la pluralité de couches (61 à 65) comprenant des composés semiconducteurs représentés chacun par la formule:

$$(Al_yGa_{1-y})_xIn_{1-x}P$$

dans laquelle $0 \leqq y \leqq 1$ et $0 \leqq x \leqq 1$.

2. Procédé selon la revendication 1, dans lequel des couches choisies parmi la pluralité de couches (61 à 65) sont dopées par un dopant de Se ou Zn.

3. Procédé selon la revendication 1 ou la revendication 2, dans lequel ledit gaz de composés triéthylés est porté par un gaz vecteur d'hydrogène en une concentration inférieure à 0,1%.

4. Procédé selon la revendication 1, la revendication 2 ou la revendication 3, dans lequel ladite phosphine est portée par un gaz vecteur d'hydrogène en une concentration inférieure à 10%.

5. Procédé selon l'une des revendications précédentes, dans lequel ledit mélange de gaz circule au-dessus du substrat (1) à une vitesse de 80 cm/min.

6. Appareil de croissance en phase gazeuse (10) pour la fabrication d'un dispositif semiconducteur émetteur de lumière par croissance épitaxiale de composés semiconducteurs III—V, l'appareil (10) comprenant:

un four réactionnel atmosphérique (10); et

un support de substrat (13) disposé dans ledit four (10) de telle façon qu'un passage de gaz (16) ayant une entrée (16a) soit formé entre le support de substrat (13) et une paroi latérale interne (11a) du four réactionnel (11); caractérisé par:

un premier orifice d'alimentation en gaz de départ (17) situé au niveau de l'entrée (16a) du passage de gaz (16) et à travers lequel des composés triéthylés des métaux du groupe III sont amenés à s'écouler;

et un second orifice d'alimentation en gaz de départ (18) situé entre l'entrée (16a) du passage de gaz (16) et le premier orifice d'alimentation en gaz de produit de départ (17) et destiné à l'écoulement de la phosphine;

le second orifice d'alimentation en gaz de départ (18) étant incliné par rapport au premier orifice d'alimentation en gaz de départ (17), les premier et second orifices d'alimentation en gaz de départ (17, 18) ayant sensiblement la même forme et les mêmes dimensions, les gaz des composés triéthylés des métaux du groupe III et de la phosphine circulant depuis les premier et second orifices d'alimentation en gaz de départ (17, 18), respectivement, et étant mélangés immédiatement en amont d'un substrat (1) disposé sur le support de substrat (13) qui est situé à proximité de l'entrée (16a) du passage de gaz (16), de sorte que le mélange gazeux circule au-dessus et le long de la surface du substrat.

7. Appareil (10) selon la revendication 6, comprenant en outre un moyen de chauffage (14) pour chauffer le substrat (1) à une température de 580 à 630°C.

8. Appareil (10) selon la revendication 7 ou la revendication 8, dans lequel ledit moyen de chauffage (14) entoure ledit four réactionnel (11).

9. Appareil (10) selon la revendication 6, la revendication 7 ou la revendication 8, dans lequel le second orifice d'alimentation en gaz de départ (18) est à angle droit par rapport au premier orifice d'alimentation en gaz de départ (17).

10. Appareil (10) selon l'une des revendications 6 à 9, dans lequel les premier et second orifices d'alimentation en gaz de départ (17, 18) ont sensiblement la même largeur et la même hauteur.

11. Appareil (10) selon l'une des revendications 6 à 10, dans lequel ledit support de substrat (13) et un substrat (1) disposé sur celui-ci sont placés en dessous de la surface inférieure de l'orifice d'alimentation en gaz (17).

FIG. 1

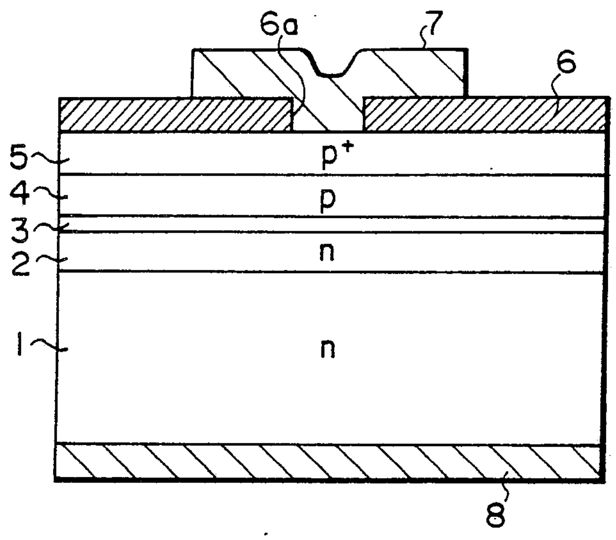


FIG. 4

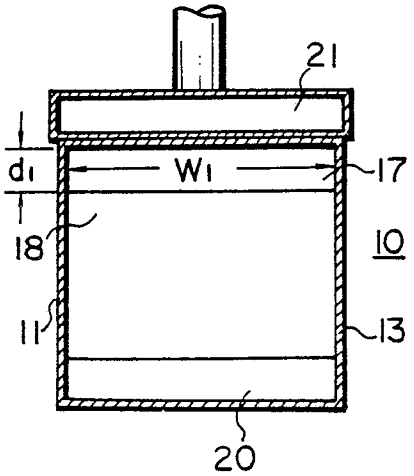

FIG. 2

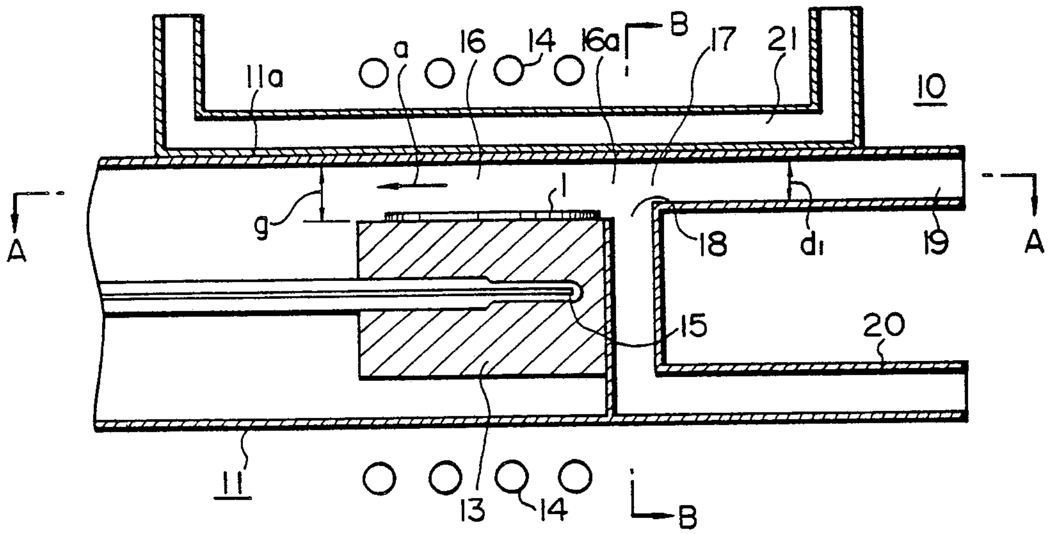
a
16
14
16a
B
17
21
10
11a
g
1
18
d1
19
A
A
15
20
11
13
14
B

FIG. 3

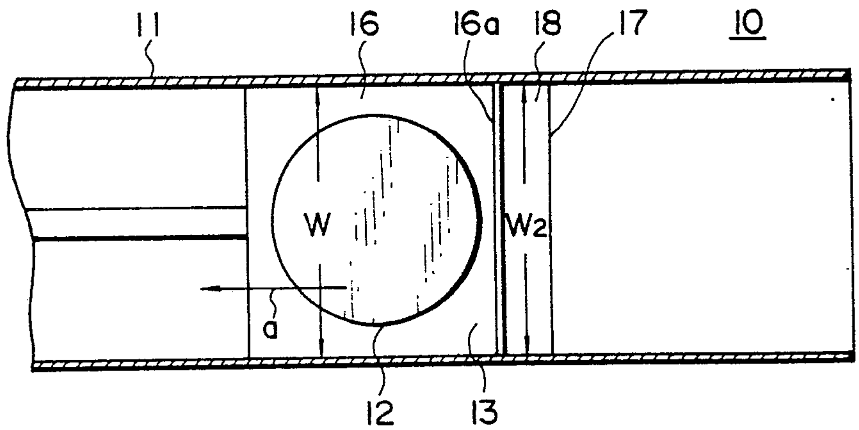
11
16
16a
18
17
10
W
W2
a
12
13

FIG. 5

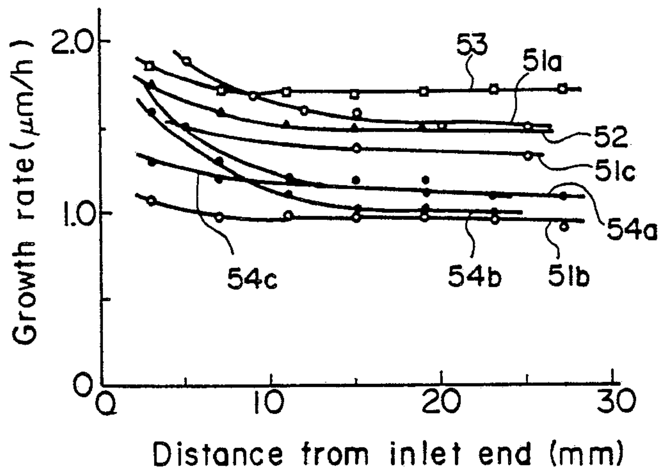
Growth rate (μm/h)
2.0
1.0
0
0
10
20
30
Distance from inlet end (mm)
53
51a
52
51c
54a
54c
54b
51b

FIG. 6

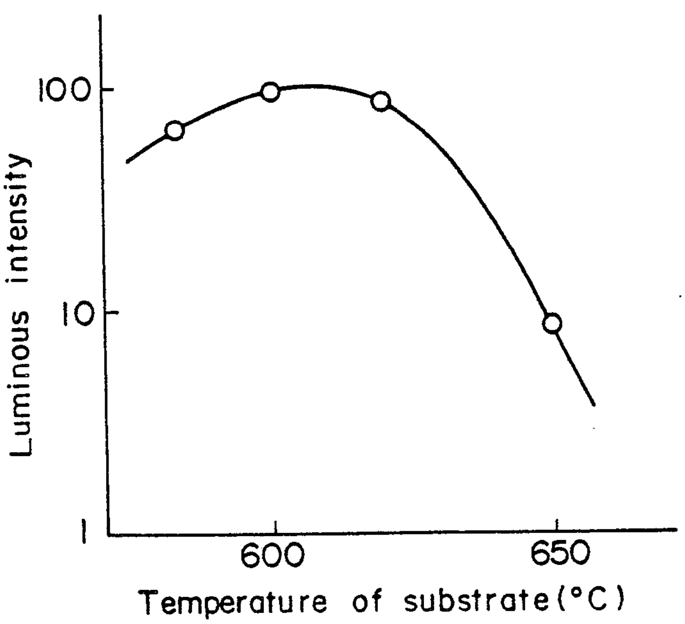
Luminous intensity
100
10
1
600
650
Temperature of substrate (°C)

FIG. 7

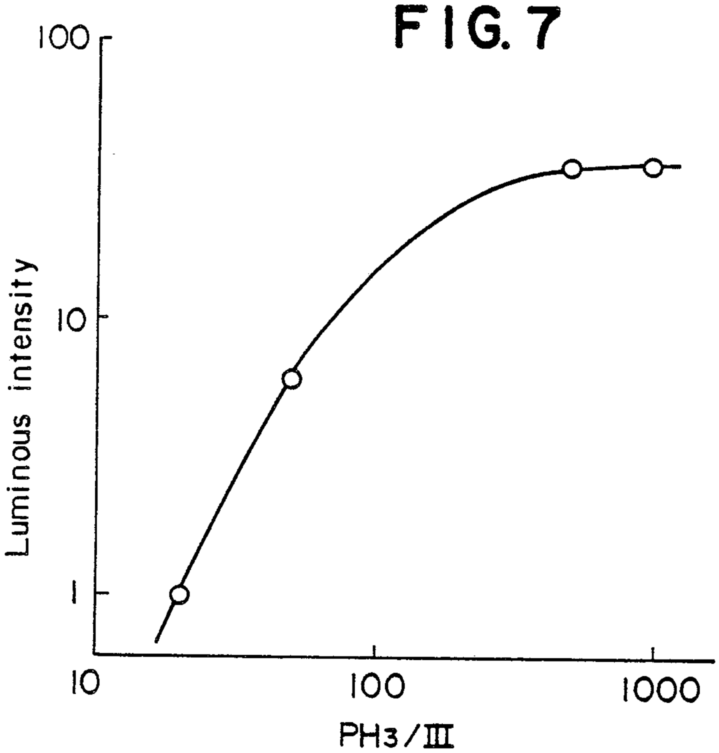
100
10
1
Luminous intensity
10
100
1000
PH3 / III

FIG. 8

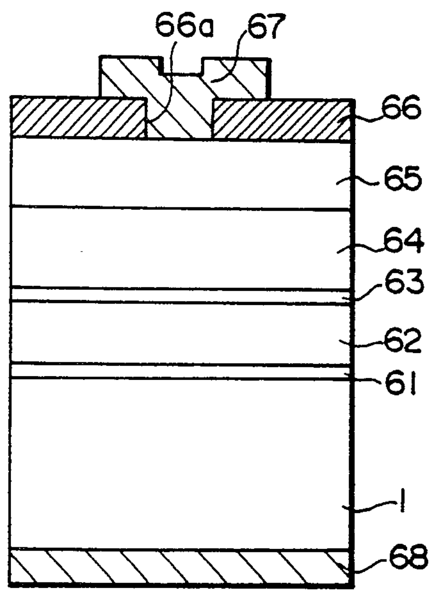
66a
67
66
65
64
63
62
61
1
68

FIG. 9

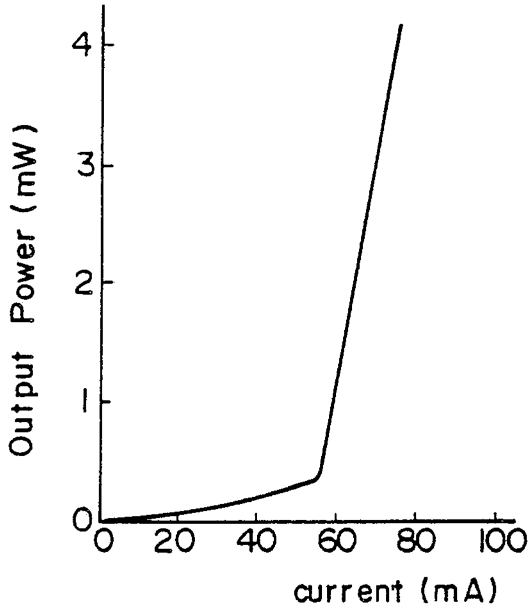
Output Power (mW)
0
1
2
3
4
0
20
40
60
80
100
current (mA)

FIG. 10

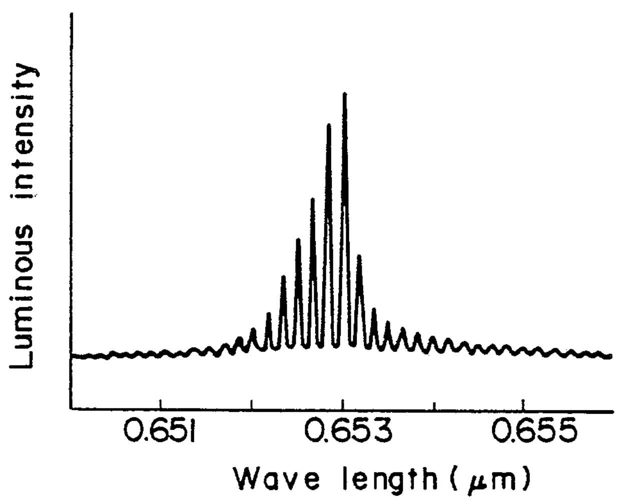
Luminous intensity
0.651
0.653
0.655
Wave length (μm)